# EUROPEAN PATENT SPECIFICATION

(11) **EP 0 660 470 B1**
(45) Date of publication and mention of the grant of the patent: **19.03.1997**
(21) Application number: 94119836.8
(22) Date of filing: 15.12.1994
(51) Int. Cl.: H01S 3/13, H01S 3/133

(54) **Method of and device for stabilization of the emission wavelength of a laser**
Verfahren und Vorrichtung zur Emissionswellenlängenstabilisierung eines Lasers
Méthode et dispositif de stabilisation de la longueur d'onde d'émission d'un laser

(30) Priority: 16.12.1993 IT TO930954
(43) Date of publication of application: 28.06.1995
(73) Proprietor: CSELT Centro Studi e Laboratori Telecomunicazioni S.p.A., I-10148 Turin (IT)
(72) Inventor: Gambini, Piero, Torino (IT)
(74) Representative: Riederer Freiherr von Paar zu Schönau, Anton

(56) References cited:
- IEEE PHOTONICS TECHNOLOGY LETTERS, APRIL 1993, USA, VOL. 5, NR. 4, PAGE(S) 472 - 474, ISSN 1041-1135 Bertinetto F et al 'Stabilization of the emission frequency of 1.54 mu m DFB laser diodes to hydrogen iodide'
- IEE PROCEEDINGS J (OPTOELECTRONICS), APRIL 1993, UK, VOL. 140, NR. 2, PAGE(S) 115 - 118, ISSN 0267-3932 Muhammad F A et al 'Sensitivity enhancement of D-fibre methane gas sensor using high-index overlay'

## Description

The present invention refers to lasers, and, more particularly, regards a method and a device for stabilization of the emission wavelength of a laser, such stabilization being obtained by locking the emission wavelength to an absorption line of a gas.

Preferably, though not exclusively, the invention can be used for stabilization of the emission wavelength of a semiconductor laser acting as source in an optical communication system.

It is known that the laser emission wavelength is subjected to fluctuations and that, consequently, lasers are associated to control circuits to stabilize such a wavelength. In certain applications the stabilization must be absolute, i.e., independent from the environment, so that the source remains fairly stable both in the short and the long term and reproducibility of the emission wavelength is good. Such applications include metrology (measurement of frequencies, lengths, etc.), wavelength division multiplexing, optical communications, where a stable and accurate wavelength reference must exist in order to control transmitters at different locations or to ensure correct identification of the various channels, etc.

In general, absolute stabilization, especially of semiconductor lasers, is obtained by locking the emission wavelength of the laser to an absorption line of a gas having an absorption spectrum with lines whose wavelength is near the emission wavelength of the source (typically, in a neighbourhood of 1.5µm for optical communications applications). Several techniques have been proposed to implement the locking; two examples are described by F. Bertinetto et al. in the papers: "Stabilization of the Emission Frequency of 1.54 µm DFB Laser Diodes to Hydrogen lodide" , IEEE Photonics Technology Letters, Vol. 4, No. 4, April 1993, and "Performance and Limitations of Laser Diodes Stabilized to the Sides of Molecular Absorption Lines of Ammonia", Review of Scientific Instruments, 64 (8), August 1993, respectively for the locking to the peak and to the sides of the line used.

In general, whatever technique is used, the radiation emitted by the laser is adequately modulated and sent into a cell containing the gas, the output radiation is detected, an error signal, representing the sign and the magnitude of the shift of the actual laser wavelength relative to the line wavelength (and thus to the nominal emission wavelength), is derived through a feed-back loop from the detected signals, and is fed to the laser control circuits. Transfer of radiation from the source to the cell and from the cell to the detector takes place in free space.

An inconvenience of known stabilization systems is that in many cases the signal-to-noise ratio in the feed-back loop is relatively limited, also because of the limited absorption of the gas used. Greater absorption can be obtained by using long cells or multiple-path cells. It is not very practical, however, to consider cells longer than a few tens of centimetres, especially in applications to field optical fibre systems. Furthermore, in such applications, in which lasers are used with a fibre pig-tail for waveguide connection between the source and the fibre which is the transmission line, there is also the further drawback that guided propagation must be abandoned to have radiation interaction with the gas, with possible troubles in alignment stability, divergence of the beam over long paths, etc.

The purpose of the invention is to provide a method and a device for stabilization of the above type, in which the inconveniences arising from free space propagation of the radiation to be stabilized are eliminated.

According to the invention, a method is given in which the radiation to be stabilized is made to interact with the gas while it is guided along an optical waveguide traversing an environment containing the gas, the waveguide being such as to give rise to an evanescent field also propagating outside the waveguide. An evanescent field is a time varying electromagnetic field whose field amplitude decreases very rapidly and monotonically, but without an accompanying phase shift, in a particular direction, and without being due to absorption.

The device implementing the method includes means for sending the radiation emitted by a laser into a cell containing a gas which has an absorption line at a wavelength near the nominal source wavelength, as well as means for detecting the radiation present at the cell output and for deriving an error signal from the signals resulting from the detection; the sending means include an optical waveguide of which a portion is located inside the cell and which is connected to the detection means and has such guiding characteristics as to give rise to an evanescent field also propagating around it, thus ensuring interaction between radiation and the gas contained in the cell.

Advantageously, the optical waveguide guide is a "D" fibre.

The invention will be now disclosed with reference to the enclosed drawings, in which:
- Figure 1 is a schematic diagram of the device according to the invention;
- Figure 2 is a cross section of a D fibre, also showing the behaviour of the field within the section.

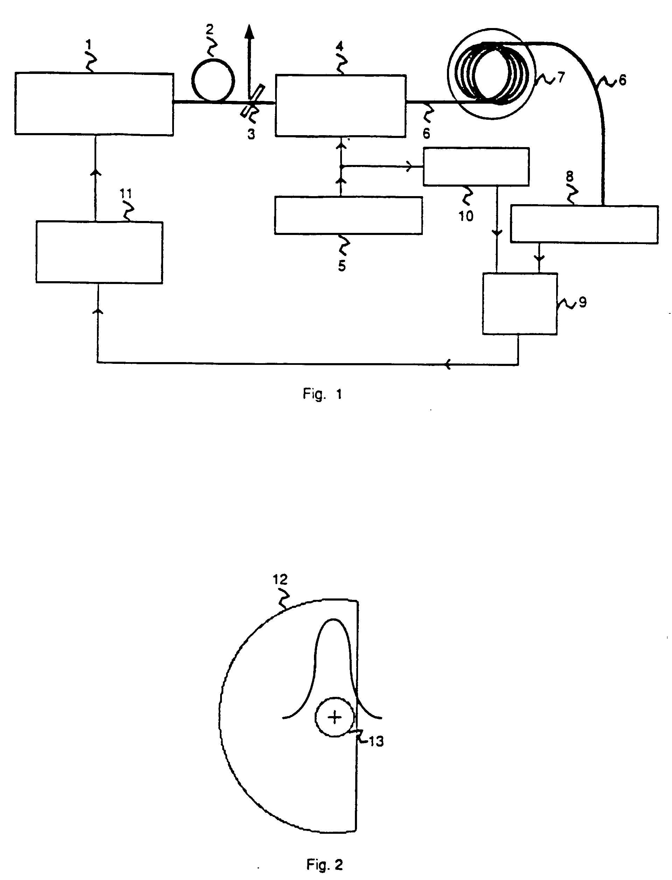

Figure 1 shows the device according to the invention in the non limitative example in which the signal from the source to be stabilized is phase-modulated and the locking is done with respect to the peak of the absorption line, as described in the first of the two above mentioned papers of F. Bertinetto et al. The invention is at any rate independent of the particular locking technique used. In the figure, thick lines represent optical waveguides and thin ones electrical connections.

This being given, the signal emitted by source 1, for instance a semiconductor laser already associated with a fibre pig-tail, is sent to a fibre stub 2. As known, "pig-tail" means a short length of fibre connected to a device, e . g. a laser, to make its connection with another device or with a fibre easier. In the drawing the pig-tail is included into the source 1. Through power splitting device 3 the signal is split into two parts, one part being the useful signal and the other being used for stabilization. The latter part is sent to an optical phase modulator 4 driven by a radio-frequency signal provided by generator 5. The phase-modulated signal is collected by a fibre 6 passing, for some of its length, inside a cell 7 filled with a gas having absorption lines which can be used for wavelength stabilization of source 1.

Fibre 6 enters or leaves cell 7 through apertures sealed with, for example, epoxy resin. Outside of cell 7, fibre 6 terminates on a photo-detector 8, whose output is connected in turn to mixer 9 which also receives signals from generator 5. A phase-shifting device 10 between generator 5 and mixer 9 sets the correct phase relationship between the modulating signal and the cell output signal. The mixer output is a signal whose amplitude and sign depend on the shift between the actual emission wavelength of laser 1 and the nominal wavelength; such signal, adequately filtered in loop filter 11, drives control circuits of laser 1 (integrated into the same block representing the source). Depending on the type of laser, the signal output by filter 11 will adjust the laser injection current, or the temperature, or the position of a mirror, etc.

Fibre 6 is advantageously a "D" fibre. A "D" fibre owes its name to the shape of its cross section. As it can be seen from Figure 2, cladding 12 of the fibre has a flat part, obtained by axially cutting the preform, and the core 13 comes very close to the flat part. The electromagnetic field thus presents tails (evanescent field) propagating in the environment around the fibre, which environment can thus affect a signal transmitted along the fibre itself. Therefore, by using such fibres, the interaction is obtained between the radiation emitted by source 1 and the gas contained in cell 7, as required for locking to an absorption line, even though propagation of the radiation is guided within the cell.

The system herein described eliminates the above mentioned inconveniences. Indeed, a fairly long fibre stub can be placed inside a cell 7 even of reduced size, so that there is a long region of interaction between radiation emitted by laser 1 and the gas in a limited room. Moreover, thanks to the fact that the radiation to be stabilized is guided from the source up to the detector, no optical misalignment occurs, and optimum mechanical stability of the device is ensured.

It is evident that the above description is merely a non limitative example, and that variants and modifications are possible which are within the scope of the invention as defined in the claims.

## Claims

1. Method for absolute stabilization of the emission wavelength of a semiconductor laser by locking such wavelength to an absorption line of a gas, characterized in that the radiation emitted by the laser (1) is made to interact with the gas while it is guided along an optical waveguide (6) which passes from the laser through an environment (7) containing the gas to a detector for detecting the radiation at the output of the environment, whereby an error signal is obtained from signals resulting from the detection, said optical waveguide having such guiding characteristics as to give rise to an evanescent field propagating outside the waveguide itself in order to ensure interaction between the radiation and the gas contained in the environment.

2. Method according to claim 1, characterized in that as such waveguide (6), a "D" fibre is used.

3. Device for absolute stabilization of the emission wavelength of a semiconductor laser, including means (2, 3, 4, 5, 6) for sending a radiation emitted by the laser (1) into a cell (7) containing a gas which has an absorption line at a wavelength near the nominal source wavelength, as well as means (8, 9, 10, 11) for detecting the radiation at the output of cell (7) and obtaining an error signal from signals resulting from the detection, characterized in that the sending means (2, 3, 4, 5, 6) include an optical waveguide (6) which passes through the cell (7), is connected to the detection means (8) and has such guiding characteristics as to give rise to an evanescent field propagating outside the waveguide itself, in order to ensure interaction between the radiation and the gas contained in the cell (7).

4. Device according to claim 3, characterized in that said waveguide (6) is a "D" fibre.

## Patentansprüche

1. Verfahren zur absoluten Stabilisierung der Emissionswellenlänge eines Halbleiterlasers durch Ketten dieser Wellenlänge an eine Absorptionslinie eines Gases, dadurch gekennzeichnet, daß man die vom Laser (1) emittierte Strahlung mit dem Gas in Wechselwirkung treten läßt, während sie entlang einem optischen Wellenleiter (6) geführt ist, der vom Laser durch eine das Gas enthaltende Umgebung (7) hindurch zu einem Detektor zum Feststellen der Strahlung am Ausgang der Umgebung verläuft, wobei aus aus der Feststellung resultierenden Signalen ein Fehlersignal erhalten wird und der optische Wellenleiter solche Leitungscharakteristiken hat, daß er zur Sicherstellung der Wechselwirkung zwischen der Strahlung und dem in der Umgebung befindlichen Gas ein außerhalb des Wellenleiters fortschreitendes evaneszentes Feld erzeugt.

2. Verfahren nach Anspruch 1, dadurch gekennzeichnet, daß man als diesen Wellenleiter (6) eine "D"-Faser verwendet.

3. Vorrichtung für die absolute Stabilisierung der Emissionswellenlänge eines Halbleiterlasers, mit Einrichtungen (2, 3, 4, 5, 6) zum Senden einer vom Laser (1) in eine Zelle (7), die ein Gas enthält, das eine Absorptionslinie bei einer Wellenlänge nahe der Nennwellenlänge der Quelle aufweist, emittierten Strahlung sowie Einrichtungen (8, 9, 10, 11) zum Feststellen der Strahlung am Ausgang der Zelle (7) und zum Erhalten eines Fehlersignals von aus der Feststellung erhaltenden Signalen, dadurch gekennzeichnet, daß die sendenden Einrichtungen (2, 3, 4, 5, 6) einen optischen Wellenleiter (6) umfassen, der durch die Zelle (7) verläuft, mit den feststellenden Einrichtungen (8) verbunden ist und eine solche Wellenleitcharakteristik hat, daß er ein außerhalb des Wellenleiters fortschreitendes evaneszentes Feld erzeugt, um eine Wechselwirkung zwischen der Strahlung und dem in der Zelle (7) enthaltenen Gas sicherzustellen.

4. Vorrichtung nach Anspruch 3, dadurch gekennzeichnet, daß der Wellenleiter (6) eine "D"-Faser ist.

## Revendications

1. Méthode pour la stabilisation absolue de la longueur d'onde d'émission d'un laser à semi-conducteur au moyen du verrouillage de cette longueur d'onde à la raie d'absorption d'un gaz, caractérisé en ce que le rayonnement émis par le laser (1) est fait interagir avec le gaz pendant qu'il est guidé le long d'un guide d'onde optique (6) qui passe du laser, à travers un milieu (7) contenant le gaz, à un détecteur pour détecter le rayonnement à la sortie du milieu, un signal d'erreur étant obtenu des signaux résultant de la détection, ledit guide d'onde optique ayant des caractéristiques de guidage telles qu'il donne origine à un champs évanescent se propageant à l'extérieur du guide d'onde, de façon à assurer l'interaction entre le rayonnement et le gaz contenu dans le milieu.

2. Méthode selon la revendication 1, caractérisé en ce que, comme guide d'onde (6), on utilise une fibre en "D".

3. Dispositif pour la stabilisation absolue de la longueur d'onde d'émission d'un laser à semi-conducteur, comprenant des moyens (2, 3, 4, 5, 6) pour envoyer un rayonnement émis par le laser (1) dans une cellule (7) contenant un gaz qui a une raie d'absorption à une longueur d'onde proche de la longueur d'onde nominale de la source, ainsi que des moyens (8, 9, 10, 11) pour détecter le rayonnement à la sortie de la cellule (7) et obtenir un signal d'erreur à partir des signaux résultant de la détection, caractérisé en ce que les moyens d'envoi (2, 3, 4, 5, 6) comprennent un guide d'onde optique (6) qui passe par la cellule (7), qui est connecté aux moyens de détection (8) et qui a des caractéristiques de guidage telles qu'il donne origine à un champs évanescent se propageant à l'extérieur du guide d'onde, de façon à assurer l'interaction entre le rayonnement et le gaz contenu dans la cellule (7).

4. Dispositif selon la revendication 3, caractérisé en ce que ledit guide d'onde (6) est une fibre en "D".
